# EUROPEAN PATENT APPLICATION

(11) **EP 2 682 363 A1**
(43) Date of publication of application: **08.01.2014**
(21) Application number: 12175390.9
(22) Date of filing: 06.07.2012
(51) Int. Cl.: B81C 1/00

(54) **Method for producing a mems device including a vapour release step**

(71) Applicant: IMEC, 3001 Leuven (BE); NXP B.V., 5656 AG Eindhoven (NL)
(72) Inventor: Boccardi, Guillaume, 3001 Leuven (BE); Du Bois, Bert, 3001 Leuven (BE)
(74) Representative: Clerix, André

(57) **Abstract**

The present invention is related to a method for producing a Micro-Electromechanical System (MEMS) device, comprising:
- Depositing a sacrificial oxide layer on a substrate,
- Depositing one or more structural layers on said sacrificial oxide layer and patterning said structural layers to form a structure,
- Removing the sacrificial layer by vapour etching,
to thereby release a portion of said structure,

wherein the step of depositing a sacrificial oxide layer comprises depositing a first layer (7) of a first sacrificial oxide having a first density, and depositing on said first layer a second layer (8) of a second sacrificial oxide, the second layer having a higher density than the first layer. The method allows to protect a first structural layer deposited on and in contact with the second sacrificial oxide layer, said vapour etching step having low selectivity of said first structural layer towards said first sacrificial oxide layer. Said first structural layer may be a silicon nitride layer protecting the backplate of a MEMS microphone.

## Description

### Field of the Invention

The present invention is related to Micro-Electromechanical Systems (MEMS) devices, in particular to a method for producing a device wherein a sacrificial oxide is removed during the production process.

### State of the art.

In MEMS processing, the use of a sacrificial oxide layer is well known. Structural layers are deposited and patterned on top of the sacrificial oxide layer, which is subsequently removed by etching. In the current MEMS microphone flow for example, the etching of the sacrificial oxide is done by a wet etch followed by a t-butanol drying process. This approach has a number of disadvantages e.g.:
- High chance of stiction between membrane and back-plate
- Damaged back-plates or damaged membranes, due to mechanical forces during etching/drying
- High defects count

An improved way of etching seems to be vapour etching, in particular vapour hydrofluoric acid (HF) etching (known as Vapour HF or VHF). This process should reduce the mechanical forces on devices (less mechanical damage), reduced stiction (no surface tension forces due to liquids in the cavity) and reduced defects due to better equipment/process.

A potential problem of VHF etching is the relatively low selectivity of the silicon nitride layer Si₃N₄ (at the cavity side of back-plate) towards oxide. In MEMS microphones, the nitride layer serves two roles:
- Anti-stiction layer to prevent stiction between membrane and back-plate during processing/operation (poly Si-epi Si mechanical contact).
- Electrical isolation.
Since the nitride layer is much thinner than the sacrificial oxide, severe damage may occur to the nitride layer during the removal of the sacrificial oxide by VHF etching.

### Summary of the invention

The invention is related to a method that may be applied in the production of MEMS microphones or other MEMS devices, taking advantage of the above described beneficial effects of vapour etching, while the negative aspects are neutralized or diminished. The method of the invention is disclosed in the appended claims.

The invention is thus related to a method for producing a Micro-Electromechanical System (MEMS) device, comprising the steps of:
- Depositing a sacrificial oxide layer on a substrate,
- Depositing one or more structural layers on said sacrificial oxide layer, preferably on and in contact with said sacrificial oxide layer, and patterning said structural layers to form a structure,
- Removing the sacrificial layer by vapour etching, to thereby release a portion of said structure,
wherein the step of depositing a sacrificial oxide layer comprises:
- depositing a first layer of a first sacrificial oxide having a first density, and
- depositing on said first layer a second layer of a second sacrificial oxide, the second layer having a higher density than the first layer.
The patterning of the structural layers may involve the etching of openings or trenches. The sacrificial oxide layer may be removed through these openings or trenches by the vapour etching step, to thereby release said structure.

According to an embodiment, said structural layers comprise a first layer deposited on and in contact with the second sacrificial oxide layer, said vapour etching step having low selectivity of said first structural layer towards said first sacrificial oxide layer. Said first structural layer may be a silicon nitride layer. Low selectivity means that there is no or substantially no selectivity.

According to an embodiment, the step of patterning said structural layers comprises an etching step, wherein said etching stops on the first sacrificial layer.

According to an embodiment, said MEMS device is a microphone, wherein said substrate is a semiconductor substrate carrying on its surface an oxide layer and thereon a membrane element, and wherein said one or more structural layers consist of:
- a protective layer deposited on and in contact with the second sacrificial layer, after producing first trenches in said second sacrificial layer, and
- a back-plate forming layer deposited on the protective layer,
and wherein the step of patterning the structural layers is done by etching a set of second trenches in between said first trenches, wherein said etching stops on the first sacrificial layer, and wherein during the vapour etch also a portion of the oxide layer that is present on the semiconductor substrate is removed.

In the latter embodiment, the substrate may be a silicon substrate carrying a thermal silicon oxide layer on its surface and thereon a silicon membrane structure, wherein said protective layer is a silicon nitride layer and said back-plate forming layer is a polysilicon layer.

In the method of the invention, said vapour may be hydrofluoric acid (HF) vapour. According to an embodiment, the etch rate of said first sacrificial oxide layer is at least five times higher than the etch rate of said second sacrificial oxide layer.

### Brief description of the figures

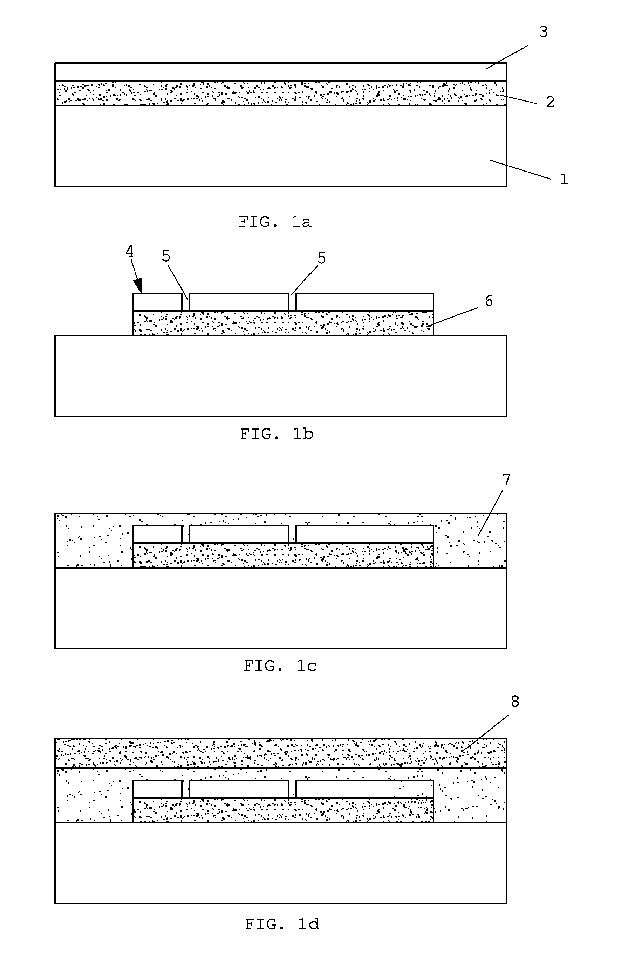

Figures 1a to 1i illustrate the steps of a method according to the invention, for producing a micro-electromechanical microphone device.

### Detailed description of the invention

The method is described in detail on the basis of a preferred embodiment: the fabrication of a MEMS-microphone device on an SOI wafer. Figure 1a shows the starting material: an SOI wafer comprising a base substrate 1 (preferably a Si-wafer), a silicon oxide layer 2 (often referred to as the BOX layer, buried oxide layer) and a silicon top layer 3. The latter two layers are patterned by a standard lithography technique including a dry etch step, to form a membrane element 4 (see figure 1b), with holes 5 provided in the membrane. This membrane structure with holes is known as such in the art. The remaining portion 6 of the BOX layer is a thermal oxide (formed by thermal oxidation of the base substrate), having a high density. On to the structure of figure 1b, the sacrificial oxide layer structure according to the invention is deposited. First a lower density layer 7 is deposited (figure 1c), preferably a TEOS oxide, i.e. a layer of silicon oxide (SiOₓ, with x preferably equal to 2) deposited by the known Chemical Vapour Deposition (CVD) technique, using TEOS (Tetra-ethyl-ortho-silicate) as the precursor. This is what is currently used as the single sacrificial oxide layer in MEMS microphone fabrication. In accordance with the invention, a second sacrificial layer 8 is then deposited (figure 1d) onto the first. The second layer is a layer of higher density than the first. For example, it can be a silicon oxide layer deposited by the known HDP (High Density Plasma) deposition technique, using silane and oxygen as the precursor.

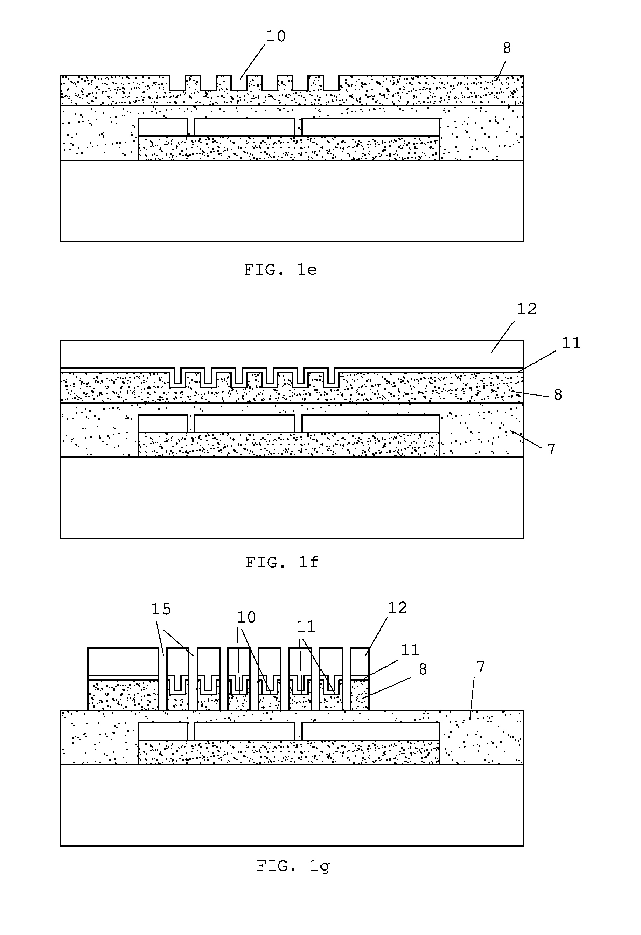

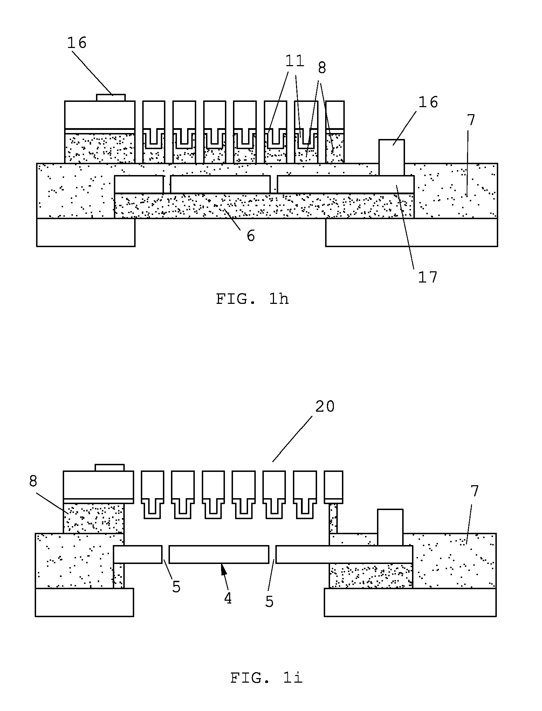

Then a number of trenches 10 are etched in the surface of the HDP oxide layer 8 (figure 1e), followed by the deposition of a layer 11 of silicon nitride deposited conformally on the surface of the HDP layer and the trenches, and a layer 12 of polysilicon deposited on the silicon nitride (figure 1f). The structural layers 11 and 12 will form the back plate of the microphone. Both these layers are preferably deposited by the known LPCVD technique (Low Pressure Chemical Vapour Deposition). Polysilicon and nitride are then patterned by standard lithography including a dry etch step (figure 1g), to form trenches 15 formed in between and parallel to the trenches 10 previously filled with nitride and polysilicon. This etch step stops on the low density (TEOS) sacrificial oxide layer 7. So the HDP layer 8 is etched also. The HDP layer 8 remains only underneath the nitride portions 11, see figure 1g. The metal contacts 16 are then formed for contacting the membrane at a lateral contact portion 17 (which is preferably a contact pad extending away from the circular circumference of the membrane, as illustrated for example in document EP2420470, incorporated herein by reference). After that, the wafer back-side is thinned down by a grinding step. A Deep Reactive Ion Etching (DRIE) step, which is a technique known as such in the art, is then performed on the back-side to reach the BOX portion 6 (figure 1h).

Then the HF vapour etch step is performed (figure 1i), wherein the portions of the sacrificial layers 6/7/8 that are situated around the membrane 4 are removed, leading to the release of the membrane 4 and back-plate 20 and thereby to the finished microphone device. Because of its lower density, the TEOS layer 7 is etched at a higher rate than the HDP layer 8. The HDP layer 8 thus protects the nitride portions 11 during the HF vapour etch.

The invention is not limited to the microphone embodiment, but it is applicable to any MEMS structure where a layer, deposited on the sacrificial oxide, is in danger of being affected during a vapour etching step, i.e. a layer for which the vapour etch step exhibits low selectivity with respect to the low-density part of the sacrificial layer. Examples of other MEMS devices to which the invention is applicable are pressure sensors or RF switches. Instead of HF, any suitable etching vapour can be used in the method of the invention. The difference in density between the first and second sacrificial oxide layers is preferably such that the etch rate by the applied vapour etch is at least five times higher for the first sacrificial oxide (lower density) than for the second sacrificial oxide (higher density). The method isn't limited to the embodiment where the vapour etch has low selectivity of the first structural layer towards the first sacrificial oxide layer. Even if the vapour etch has higher selectivity of the first structural layer towards the first sacrificial oxide layer, the addition of a second sacrificial oxide with higher density can act as a means of ensuring that the first structural layer is protected during the vapour release etch.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A method for producing a Micro-Electromechanical System (MEMS) device, comprising:
- Depositing a sacrificial oxide layer on a substrate,
- Depositing one or more structural layers (11,12) on said sacrificial oxide layer and patterning said structural layers to form a structure,
- Removing the sacrificial layer by vapour etching, to thereby release a portion of said structure,
wherein depositing a sacrificial oxide layer comprises:
• depositing a first layer (7) of a first sacrificial oxide having a first density, and
• depositing on said first layer a second layer (8) of a second sacrificial oxide, the second layer having a higher density than the first layer.

2. Method according to claim 1, wherein said structural layers comprise a first layer (11) deposited directly on the second sacrificial oxide layer (8), said vapour etching step having low selectivity of said first structural layer (11) towards said first sacrificial oxide layer (7).

3. Method according to claim 2, wherein said first structural layer (11) is a silicon nitride layer.

4. Method according to any one of claims 1 to 3, wherein patterning said structural layers comprises an etching step, wherein said etching stops on the first sacrificial layer (7).

5. Method according to claim 1, wherein said MEMS device is a microphone, wherein said substrate is a semiconductor substrate (1) carrying on its surface an oxide layer (6) and thereon a membrane element (4), and wherein said one or more structural layers consist of :
- a protective layer (11) deposited on and in contact with the second sacrificial layer (8), after producing first trenches (10) in said second sacrificial layer (8), and
- a back-plate forming layer (12) deposited on the protective layer (11),
and wherein patterning the structural layers is done by etching a set of second trenches (15) in between said first trenches (10), wherein said etching stops on the first sacrificial layer (7), and wherein during the vapour etch also a portion of the oxide layer (6) that is present on the semiconductor substrate is removed.

6. Method according to claim 5, wherein the substrate is a silicon substrate (1) carrying a thermal silicon oxide layer (6) on its surface and thereon a silicon membrane structure (4,5), wherein said protective layer (11) is a silicon nitride layer and said back-plate forming layer (12) is a polysilicon layer.

7. Method according to any one of the preceding claims, wherein said vapour is hydrofluoric acid (HF) vapour.

8. Method according to any one of the preceding claims, wherein the etch rate of said first sacrificial oxide layer is at least five times higher than the etch rate of said second sacrificial oxide layer.
